# EUROPEAN PATENT APPLICATION

(11) **EP 2 645 518 A2**
(43) Date of publication of application: **02.10.2013**
(21) Application number: 13156093.0
(22) Date of filing: 21.02.2013
(51) Int. Cl.: H02J 3/38, H02J 7/00

(54) **Relay welding detector of battery system and battery system which uses the detector**

(30) Priority: 28.03.2012 JP 2012072719
(71) Applicant: Hitachi Ltd., Tokyo 100-8280 (JP)
(72) Inventor: Takahashi, Toshiki, Tokyo 100-8220 (JP); Futami, Motoo, Tokyo 100-8220 (JP); Yamauchi, Shin, Tokyo 100-8220 (JP)
(74) Representative: MERH-IP Matias Erny Reichl Hoffmann

(57) **Abstract**

Provided is a battery system which can ensure high safety even when the battery system is constructed using a mechanical relay. The battery system includes: a battery module 30 where a plurality of battery cells 20 are connected to each other in series; a switching circuit 400 which is connected to the battery module 30 in series; a control unit 230 which controls the switching circuit 400; and a welding diagnosis circuit 410 which diagnoses welding of the switching circuit 400, wherein the switching circuit 400 is constituted by connecting a first relay switch 401 and a second relay switch 402 in series, and the welding diagnosis circuit 410 includes a voltage measuring device 415 which measures a voltage between the first relay switch 401 and the second relay switch 402.

## Description

### BACKGROUND OF THE INVENTION

### 1. Field of the Invention

The present invention relates to a relay welding detector mounted in a battery system and a battery system which uses the detector.

### 2. Description of the Related Art

Battery systems which have been steadily progressing recently can be used in versatile applications. A scale of a battery system differs depending on a purpose of usage. Particularly, a battery system used for suppressing the fluctuation of a load or for coping with a blackout in a server center or the like, or a battery system used for stabilizing a large-scale system in a regenerative power absorbing system for railroads, a regenerative energy system, a nuclear power plant or the like becomes a large-scale system. In such a large-scale battery system, a plurality of battery modules each of which constitutes a minimum unit in use are connected in series thus forming a battery pack, and a plurality of such battery packs are connected in parallel to each other. Such a battery system includes a relay which is connected to a battery cell in series for enhancing maintenance of the battery system or for protecting the above-mentioned battery pack when an abnormality occurs in the battery system.

For example, JP-A-2003-244854 discloses a power storage system in which one switch is provided to a storage battery device where a plurality of battery modules are connected in series.

On the other hand, in a case where a mechanical relay is used in a main circuit switch in a large-sized battery system, when only one switch is used, there is no other means which cuts off the battery pack and an external apparatus from each other when the relay is welded and hence, there arises a drawback that the battery system cannot be protected sufficiently when an abnormality occurs.

### SUMMARY OF INVENTION

The present invention has been made in view of the above-mentioned drawback, and it is an object of the present invention to provide a battery system which can ensure high safety even when the battery system is constructed using a mechanical relay.

According to one aspect of the present invention, there is provided a battery system which includes: a battery module where a plurality of battery cells are connected to each other in series; a switching circuit which is connected to the battery module in series; a control unit which controls the switching circuit; and /or a welding diagnosis circuit which diagnoses welding of the switching circuit, wherein the switching circuit is constituted by connecting a first relay switch and a second relay switch in series, and the welding diagnosis circuit includes a voltage measuring device which measures a voltage between the first relay switch and the second relay switch.

By carrying out the present invention, it is possible to provide a battery system which can ensure high safety even when the battery system is constructed using a mechanical relay.

### BRIEF DESCRIPTION OF THE DRAWINGS

Fig. 1 is a block diagram showing the overall constitution of a power generation system to which a battery system according to the present invention is applied;
Fig. 2 is a block diagram showing the hierarchical structure of a battery system according to the present invention;
Fig. 3 is a circuit diagram of the constitution of the battery module according to the present invention;
Fig. 4 is a circuit diagram of the constitution of the battery system according to the present invention;
Fig. 5 is a circuit diagram of the constitution of an area around a battery pack in the battery system shown in Fig. 4 in an enlarged manner;
Fig. 6 is a flow chart showing a method of detecting welding of a lower relay switch according to the present invention; and
Fig. 7 is a flow chart showing a method of diagnosing welding of an upper relay switch according to the present invention.

### DETAILED DESCRIPTION OF THE PREFERRED EMBODIMENTS

Hereinafter, a battery system according to an embodiment of the present invention is explained with reference to drawings.

Firstly, the overall constitution of the battery system according to the embodiment of the present invention is explained.

In a power system which uses natural energy generated by the wind-power generation, the solar power generation or the like, although the power system has an advantage that a load which affects the natural environment is small, the power generation ability of the power system is influenced by the natural environment. To explain the disadvantage more specifically, the intensity of wind energy or solar energy changes every second so that there is a fear that the power system is adversely influenced by a change in frequency or a change in voltage.

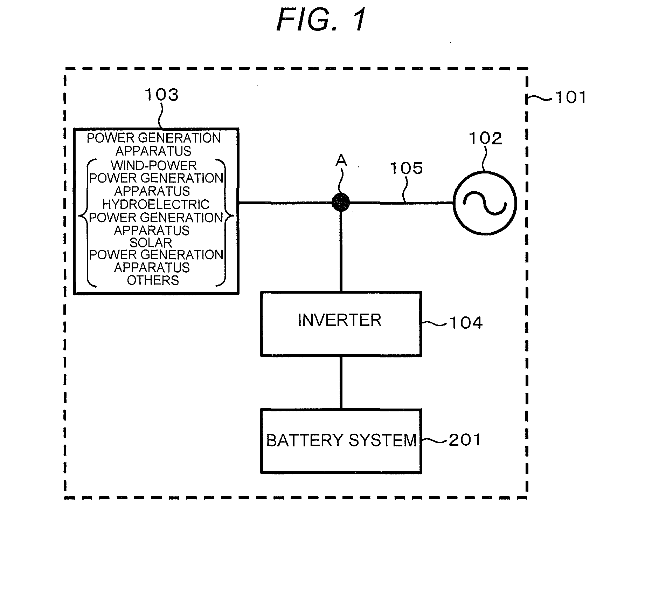

As one of approaches to overcome such a fear, there has been proposed a power system which intends to suppress a change in frequency or a change in voltage of the power system by installing a battery system to a natural energy power generation apparatus. Fig. 1 is a block diagram showing the overall constitution of the power system 101 to which a battery system 201 according to the present invention is applied.

As shown in Fig. 1, the power system 101 includes a power system 102; a power generation apparatus 103; an inverter 104; and the battery system 201 according to the present invention.

The power generation apparatus 103 has, for example, a function of supplying electric power generated using natural energy to the power system 102. The battery system 201 according to the present invention is connected to a junction A of an electric line 105 which is connected between the power generation apparatus 103 and the power system 102 via the inverter 104.

The inverter 104 has a function of converting electric power generated by the power generation apparatus 103 into DC power and transmitting the converted DC power to the battery system 201, and a function of converting DC power stored in the battery system 201 into AC power and transmitting the converted AC power to the power system 102. The supply of electric power to a load is performed via the AC power system 102.

When a natural energy power generation apparatus is adopted as the power generation apparatus 103, an output of the power generation apparatus 103 is changed by being influenced by a change in natural environment such as weather or season. This change in output becomes a factor which brings about a change in frequency or a change in voltage of the power system 102 thus lowering the quality of electric power of the power system 102.

In this respect, the battery system 201 according to the present invention functions so as to set a change in frequency or a change in voltage of the power system 102 within predetermined ranges. That is, the battery system 201 has a so-called buffer function where surplus electric power is charged in the battery system 201 when excessive electric power is supplied to the power system 102 while electric power stored in the battery system 201 is discharged when electric power becomes short. Due to such a constitution, the battery system 201 according to the present invention can suppress a change in frequency or a change in voltage of the power system 102.

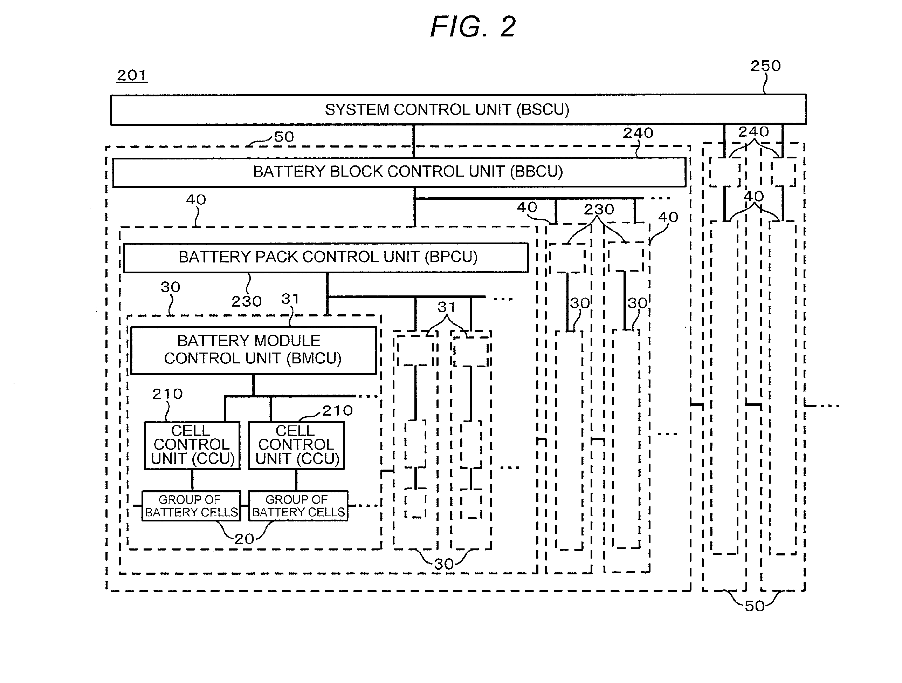

Next, the specific constitution of the battery system 201 according to the present invention is explained with reference to Fig. 2. Fig. 2 is a block diagram conceptually describing the hierarchical structure of the battery system 201 according to the present invention. The battery system 201 according to the present invention includes, by setting a battery module 30 as a minimum unit, battery packs 40 each of which includes a plurality of battery modules 30, and a battery block 50 each of which includes a plurality of battery packs 40.

The constitution of the battery module 30 is specifically explained. The battery module 30 includes: a plurality of groups of battery cells 20; a cell control unit (CCU) 210 which collects battery information on the group of battery cells 20 (for example, current information, voltage information, temperature information, charge state and the like of battery cells) ; and a battery module control unit (BMCU) 31. The cell control unit 210 also performs a balancing control between the battery cells described later. The battery information collected by the cell control unit 210 is transmitted to the battery module control unit (BMCU) 31. The battery module control unit (BMCU) 31 calculates an average charge state of the group of battery cells 20 in the battery module 30, further adds the battery information on the average charge state of the group of battery cells 20 to the previous battery information, and transmits the battery information to battery pack control units (BPCU) 230 which constitute a host control unit with respect to the battery module control unit (BMCU) 31.

The battery pack 40 includes a plurality of battery modules 30 and the battery pack control unit 230. The battery pack control unit 230 collects the battery information outputted from the respective battery module control units 31, and calculates information on an average charge state of the battery modules 30 obtained by averaging charge states of the battery modules 30 in the battery pack 40. Then, the battery pack control unit 230 adds information on the average charge state of the plurality of battery modules 30 to the battery information obtained by the battery module control unit 31, and outputs the battery information to a battery block control unit 240 which constitutes a host control unit with respect to the battery pack control unit 230.

The battery block 50 includes the plurality of battery packs 40 and the battery block control unit 240. The battery block control unit 240 collects the battery information outputted from the respective battery pack control units 230, and calculates information on an average charge state of the battery packs 40 obtained by averaging charge states of the battery packs 40 in the battery block 50. Then, the battery block control unit 240 adds information on the average charge state of the plurality of battery packs 40 to the battery information obtained by the battery pack control unit 230, and outputs the battery information to a system control unit 250 which constitutes a host control unit with respect to the battery block control unit 240. Although the explanation of this embodiment has been made on the presumption that the battery block 50 includes the plurality of battery packs 40, the number of battery packs 40 which constitute the battery block 50 may be one. In this case, the battery block control unit 240 directly outputs the battery information outputted from the battery pack control unit 230 to the system control unit 250.

In the present invention, the states of the batteries are monitored in plural layers in this manner and hence, the present invention provides the battery system 201 of high safety. Further, the battery modules 30, the battery packs 40 and the battery blocks 50 according to the present invention can be exchanged in accordance with each unit thus providing the battery system of high maintenance property.

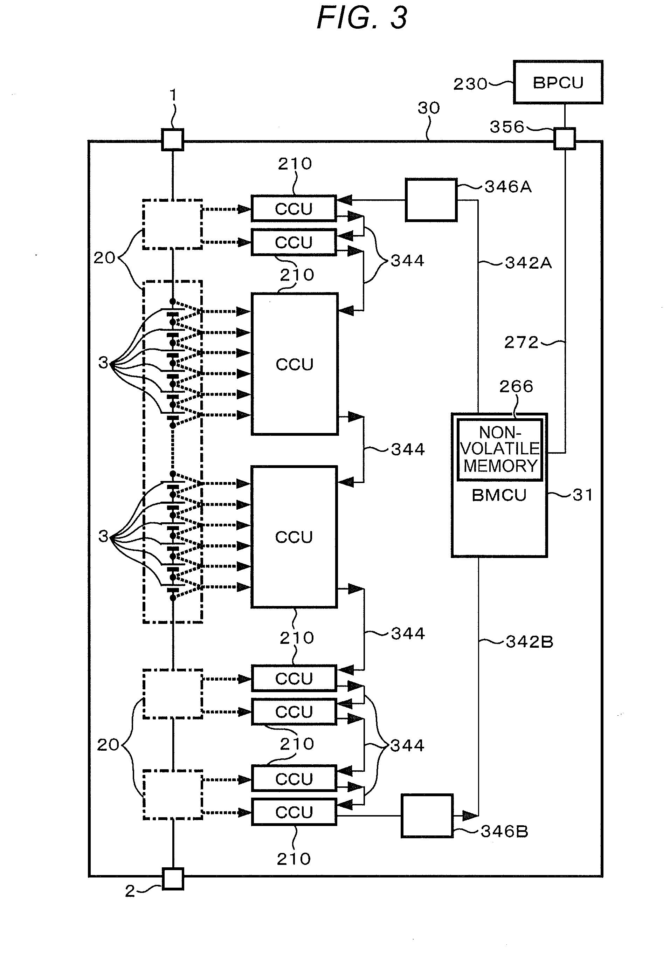

Next, the details of the battery module 30 are explained with reference to Fig. 3. The battery module 30 includes: a plurality of groups of battery cells 20; cell control units 210 which collect battery information on the groups of battery cells 20; and a battery module control unit 31 to which information on the cell control units 210 is inputted.

The group of battery cells 20 has the structure where a plurality of battery cells 3 (for example, lithium ion batteries in this embodiment) are connected in series, and battery information (current information, voltage information, charge state, temperature) on the respective battery cells 3 is constantly measured by the cell control unit 210 corresponding to the group of battery cells 20. The respective cell control units 210 are connected with each other by inter cell control unit connection lines 344 thus forming the daisy chain constitution. Accordingly, the respective cell control units 210 are connected with the battery module control unit 31 via connection lines 342A, 342B and insulation communication means 346A, 346B such as photocouplers, for example.

A non-volatile memory 266 is arranged in the inside of the battery module control unit 31, and battery information acquired by the respective cell control units 210 is stored in the non-volatile memory 266. The stored data is outputted to a battery pack control unit 230 via a communication line 272 and a module connector part 356, and the information is used for balancing between the respective battery modules 30 and the like.

On the other hand, the groups of battery cells 20 in the battery module 30 are connected with each other in series, wherein a positive pole side of the battery cells 3 is connected to a positive pole terminal 1 mounted in the battery module 30, and a negative pole side of the battery cells 3 is connected to a negative pole terminal 2 mounted in the battery module 30.

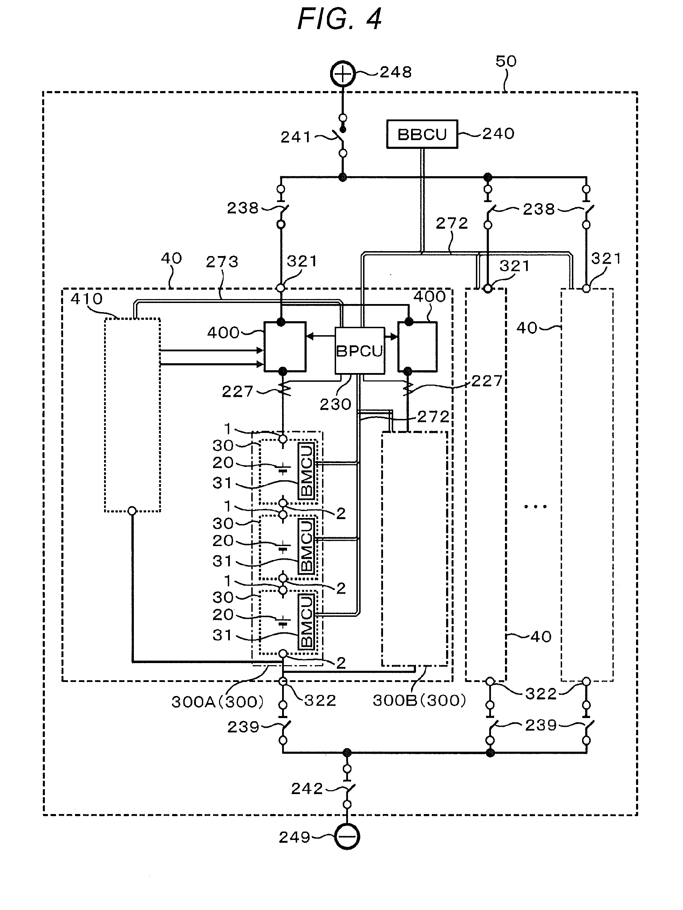

Then, the constitution of the battery packs 40 and the constitution of the battery block 50 are explained with reference to Fig. 4. Firstly, the battery pack 40 is explained. The battery pack 40 includes: battery module series connection bodies 300 (300A, 300B) where a plurality of battery modules 30 are connected to each other in series; switching circuits 400 which are connected with the battery module series connection bodies 300; a welding diagnosis circuit 410 which diagnoses welding of a relay switch which constitutes the switching circuit 400; and a battery pack control unit 230 which controls the respective battery modules 30. The switching circuit 400 and the welding diagnosis circuit 410 are explained in detail later. In the battery pack 40, the plurality of battery module series connection bodies 300 (300A, 300B) are connected to each other in parallel. Although two battery module series connection bodies 300 (300A, 300B) are connected to each other in parallel in Fig. 4 for the sake of brevity, the number of battery module series connection bodies 300 to be connected in parallel is not particularly limited to two and may be increased corresponding to a usage.

The battery pack control unit 230 performs a control of the switching circuits 400, a control of the welding diagnosis circuit 410, a control and communication of the battery module control units 31, and transmission of information to the battery block control unit 240. The control of the switching circuits 400 means, for example, a control where a DC current which flows into the battery module series connection body 300 is directly detected by a current measuring device 227, and when an abnormality is present in the electric current, the switching circuit 400 is brought into an open state thus cutting off the battery module series connection body 300 from other battery module series connection bodies 300. By controlling the switching circuit 400 in this manner, it is possible to prevent the battery module series connection body 300 having the abnormality from affecting other apparatuses or it is possible to prevent the further progress of the abnormality of the battery module series connection body 300.

On the other hand, in the battery block 50, the above-mentioned plurality of battery packs 40 are connected to each other in parallel. Further, a switching element 238 is connected to a positive-side output terminal 321 of each battery pack 40 in series, and a switching element 239 is also connected to a negative-side output terminal 322 of each battery pack 40 in series in the same manner. By bringing the switching elements 238, 239 into an open state when an abnormality occurs in the battery pack 40, it is possible to cut off the connection of the battery pack 40 with other devices and other battery packs 40 connected in parallel. Further, a switching element 241 is arranged between the construction formed by connecting the plurality of battery packs 40 to each other in parallel and a battery block positive-pole output 248, and also a switching element 242 is arranged between the construction and a battery block negative-pole output 249 which constitutes the other output. Accordingly, when an abnormality occurs in the battery block 50, it is possible to electrically cut off the battery block 50 from other battery blocks 50.

In this manner, in the battery system according to the present invention, the switching elements are provided twofold or more so that the connection of the constitutional element of the battery system can be cut off from other constitutional elements at any portion of the battery module 30, the battery pack 40 and the battery block 50 thus providing a battery system of extremely high safety.

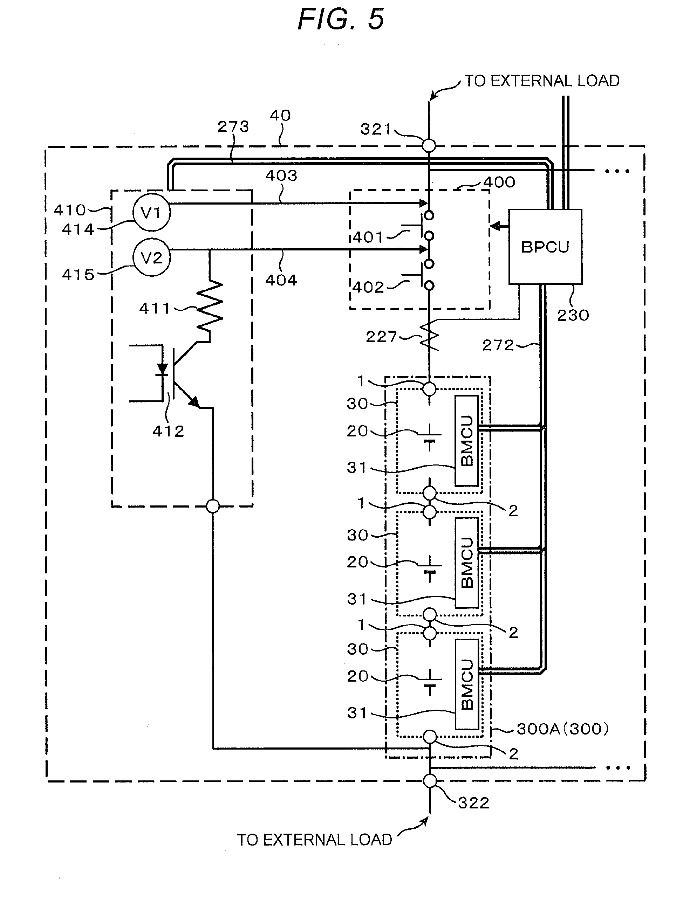

Subsequently, the details of the battery pack 40, the switching circuit 400 and the welding diagnosis circuit 410 are explained with reference to Fig. 5. Firstly, the switching circuit 400 is explained. The switching circuit 400 is constituted by connecting an upper relay switch 401 and a lower relay switch 402 to each other in series. Due to such a constitution, even when either one of these relay switches is welded, by bringing the relay switch which is not welded into an open state, the battery module series connection body 300 can be cut off and hence, the safety of the battery system is enhanced. Turning on and off of the upper relay switch 401 and the lower relay switch 402 is controlled in response to signals from the battery pack control unit 230.

Next, the welding diagnosis circuit 410 is explained.

The welding diagnosis circuit 410 includes: a voltage measuring device 414 which measures a high-potential-side voltage of the upper relay switch 401; a voltage measuring device 415 which measures a voltage between the upper relay switch 401 and the lower relay switch 402; a resistance element 411 which is connected to the voltage measuring device 415; and a switching element 412 which has one end thereof connected to the resistance element 411 and the other end thereof connected to a negative-pole side of the battery module series connection body 300. Voltage information measured by the voltage measuring devices 414, 415 is transmitted to the battery pack control unit 230 via a communication line 273, and the battery pack control unit 230 determines whether or not the upper relay switch 401 and the lower relay switch 402 are welded based on the voltage information. By adopting such a constitution, the battery pack control unit 230 can constantly determine whether or not the upper relay switch 401 and the lower relay switch 402 are welded thus further enhancing the safety and the reliability of the battery system by the provision of two relay switches.

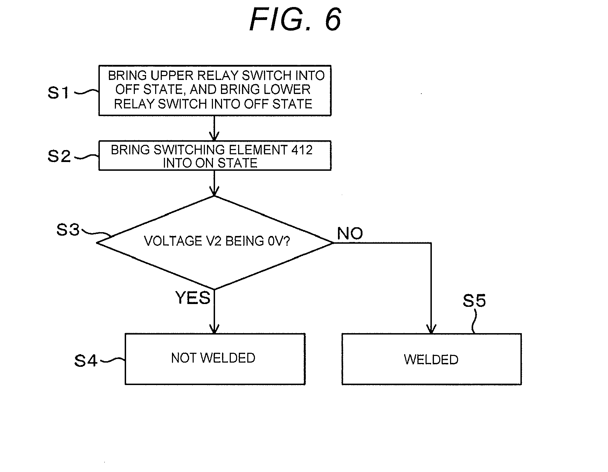

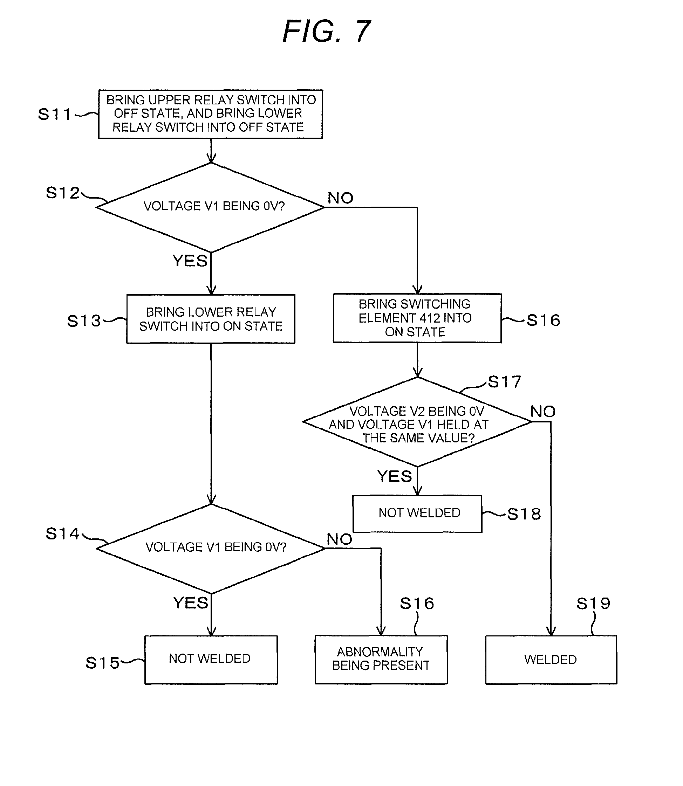

A specific method of diagnosing the welding of the relay switches is explained with reference to Fig. 6 and Fig. 7. Firstly, the method of diagnosing the welding of the lower relay switch 402 is explained with reference to Fig. 6. Firstly, in step S1, both the upper relay switch 401 and the lower relay switch 402 are brought into an OFF state. Next, in step S2, the switching element 412 of the welding diagnosis circuit 410 is brought into an ON state. Thereafter, a voltage V2 between the upper relay switch 401 and the lower relay switch 402 is measured by the voltage measuring device 415. The voltage V2 is supplied to the battery pack control unit 230 and, in step S3, the battery pack control unit 230 determines whether or not the voltage V2 is 0V. When the voltage V2 is 0V, a circuit between the upper relay switch 401 and the lower relay switch 402 is completely electrically independent and hence, the process advances to step S4 where the battery pack control unit 230 determines that the lower relay switch 402 is not welded and continues a normal operation. On the other hand, when the battery pack control unit 230 determines that the voltage V2 is not 0V, the battery pack control unit 230 determines that a closed circuit is constituted by a voltage measuring line 403, the resistance element 411, the switching element 412, the battery module series connection body 300 and the lower relay switch 402, and the process advances to step S5 where the battery pack control unit 230 determines that the lower relay switch 402 is welded, and welding of the lower relay switch 402 is displayed on a display device not shown in the drawing. In this case, for the sake of safety, an OFF state of the upper relay switch 401 is maintained.

As described above, with the use of the method of diagnosing the welding of the lower relay switch 402, the safety of the battery system can be enhanced by the simple circuit constitution. It is preferable that such a diagnosis method is carried out constantly. On the other hand, when the diagnosis method is carried out constantly, the electrical connection between the battery module series connection body 300 which is subjected to the diagnosis and other devices is cut off and hence, it is less than optimal from a viewpoint of allowing the battery module series connection bodies 300 which constitute the battery pack 40 to sufficiently exhibit its performance. Accordingly, it is preferable to perform the diagnosis using the switching circuit 400 connected to the battery module series connection body 300 whose electrical connection is cut off when balancing between the battery module series connection bodies 300 is performed. Due to such a control, the performance of the battery module 30 can be sufficiently utilized in a usual-time control and, further, the safety of the battery system can be enhanced as a whole.

Further, by connecting the welding diagnosis circuit 410 to a negative pole side of the battery module series connection body 300, the diagnosis can be performed even if the battery module series connection body 300 is exchanged with another kind of battery (for example, lead storage battery in this embodiment) in maintenance and hence, the relay welding diagnosis can be realized with the simple circuit constitution regardless of the kind of battery.

Next, the method of diagnosing the welding of the upper relay switch 401 is explained with reference to Fig. 7. Firstly, in step S11, the upper relay switch 401 and the lower relay switch 402 are brought into an OFF state. Then, a high-potential-side voltage V1 of the upper relay switch 401 is measured by the voltage measuring device 414, and the measured voltage V1 is transmitted to the battery pack control unit 230. In step S12, the battery pack control unit 230 determines whether or not the voltage V1 is 0V. When the voltage V1 is 0V, the process advances to step S13 where the lower relay switch 402 is brought into an ON state in response to an instruction from the battery pack control unit 230. Then, the voltage measuring device 414 measures the voltage V1 and transmits the voltage V1 to the battery pack control unit 230. In step S14, the battery pack control unit 230 determines again whether or not the voltage V1 is 0V. When the voltage V1 is held at 0V, the process advances to step S15 and it is determined that the upper relay switch 401 is not welded and the usual operation is continued. On the other hand, when the battery pack control unit 230 determines that the voltage V1 is not 0V, the process advances to step S16 and it is determined that an abnormality occurs in any one of the circuits and a display informing the occurrence of the abnormality in the circuit is performed on a display device not shown in the drawing. At this point of time, the battery module series connection body 300 which has a possibility that an abnormality occurs therein from the circuit is cut off, and therefore both the upper relay switch 401 and the lower relay switch 402 are brought into an OFF state.

Returning back to the explanation of the flow of the method of diagnosing the welding, when the battery pack control unit 230 determines that the voltage V1 is not 0V in step S12, the process advances to step S16 where the switching element 412 of the welding diagnosis circuit 410 is brought into an ON state. Here, a voltage V2 is measured by the voltage measuring device 415, the voltage V1 is measured by the voltage measuring device 414 again, and these voltages V2, V1 are transmitted to the battery pack control unit 230. In step S17, the battery pack control unit 230 determines whether or not the voltage V2 is 0V and the voltage V1 is set to the same value as the voltage used in step S12. When these conditions are satisfied, the circuit between the upper relay switch 401 and the lower relay switch 402 is electrically independent and hence, the process advances to step S18 and it is determined that the upper relay switch 401 is not welded. On the other hand, when the voltage V2 is not 0V and the voltage V1 is set to a value different from the voltage used in step S12, the upper relay switch 401, an external load not shown in the drawing, the switching element 412 and the resistance 411 which constitute the welding diagnosis circuit 410, and the voltage measuring line 404 constitute a closed circuit and hence, a voltage change amount of the external load not shown in the drawing is superposed on the voltage of the circuit between the upper relay switch 401 and the lower relay switch 402. Accordingly, the process advances to step S19 and it is determined that the upper relay switch 401 is welded. Then, a display informing the welding of the upper relay switch 401 is performed on a display device not shown in the drawing.

With the use of the method of diagnosing the welding of the upper relay switch 401 described above, the safety of the battery system can be enhanced with the simple constitution. It is preferable that such a diagnosis method is carried out constantly. Further, in the same manner as the method of diagnosing the welding of the lower relay switch 402 described previously, it is preferable to perform the diagnosis using the switching circuit 400 connected to the battery module series connection body 300 whose electrical connection is cut off when balancing between the battery module series connection bodies 300 is performed.

Further, by connecting the welding diagnosis circuit 410 to a negative pole side of the battery module series connection body 300, a closed circuit including an external load can be formed when an abnormality occurs and hence, even if the battery module series connection body 300 is exchanged with another kind of battery (for example, lead storage battery in this embodiment) in maintenance, the relay welding diagnosis can be realized.

As has been explained heretofore, with the use of the battery system according to the present invention, even when the battery system is constructed using mechanical relays, it is possible to provide a battery system of high safety. Further, even when the battery module is exchanged with a different kind of battery module in maintenance, the welding of a relay can be surely detected and hence, it is possible to provide a battery system where safety is further enhanced.

Features, components and specific details of the structures of the above-described embodiments may be exchanged or combined to form further embodiments optimized for the respective application. As far as those modifications are apparent for an expert skilled in the art they shall be disclosed implicitly by the above description without specifying explicitly every possible combination.

## Claims

1. A battery system comprising:
a battery module (30) where a plurality of battery cells (20) are connected to each other in series;
a switching circuit (400) which is connected to the battery module (30) in series;
a control unit (230) which controls the switching circuit (400); and a welding diagnosis circuit (410) which diagnoses welding of the switching circuit (400), wherein
the switching circuit (400) is constituted by connecting a first relay switch (401) and a second relay switch (402) in series, and
the welding diagnosis circuit (410) includes a voltage measuring device (415) which measures a voltage between the first relay switch (401) and the second relay switch (402).

2. The battery system according to claim 1, wherein the welding diagnosis circuit (410) further includes a voltage measuring device (414) which measures a high-potential-side voltage of the first relay switch (401).

3. The battery system according to claim 1 or 2, wherein the welding diagnosis circuit (410) includes a switching element (412), and the welding diagnosis circuit (410) is connected to a negative pole side of the battery module (30) via the switching element (412).

4. The battery system according to any one of claims 1 to 3, wherein the high potential side of the first relay switch (401) is connected to a load, and a negative pole side of the battery module (30) is connected to the load.

5. The battery system according to any one of claims 1 to 4, wherein a control of the switching element (412) is performed by a control unit (230) which controls the switching circuit (400).

6. A method of diagnosing a battery system which comprises: a battery module (30) where a plurality of battery cells (20) are connected to each other in series; a switching circuit (400) which is connected to the battery module (30) in series, a first relay switch (401) and a second relay switch (402) being connected in series; a control unit (230) which controls the first relay switch (401) and the second relay switch (402); and a welding diagnosis circuit (410) which includes a switching element (412) and is connected to a negative pole side of the battery module (30) via the switching element (412), the method comprising:
a first step of bringing the first relay switch (401) and the second relay switch (402) into an OFF state;
a second step of bringing the switching element (412) into an ON state after the first step; and
a third step of determining whether or not a voltage between the first relay switch (401) and the second relay switch (402) is 0V after the second step.

7. The method of diagnosing a battery system according to claim 6, wherein it is determined that the second relay switch (402) has an abnormality when the voltage between the first relay switch (401) and the second relay switch (402) is not 0V in the third step.

8. A method of diagnosing a battery system which comprises: a battery module (30) where a plurality of battery cells (20) are connected to each other in series; a switching circuit (400) which is connected to the battery module (30) in series, a first relay switch (401) and a second relay switch (402) being connected in series; a control unit (230) which controls the first relay switch (401) and the second relay switch (402); and a welding diagnosis circuit (410) which includes a switching element (412) and is connected to a negative pole side of the battery module (30) via the switching element (412), the method comprising the steps of:
a first step of bringing the first relay switch (401) and the second relay switch (402) into an OFF state;
a second step of measuring a high-potential-side voltage of the first relay switch (401) after the first step;
a third step of bringing the switching element (412) into an ON state after the second step; and
a fourth step of determining whether or not a voltage between the first relay switch (401) and the second relay switch (402) is 0V and the high-potential-side voltage of the first relay switch (401) is the same value as the voltage in the second step after the third step.

9. The method of diagnosing a battery system according to claim 8, wherein it is determined that the first relay switch (401) has an abnormality when the voltage between the first relay switch (401) and the second relay switch (402) is 0V and the high-potential-side voltage of the first relay switch (401) is not the same value as the voltage in the second step in the fourth step.
